# EUROPEAN PATENT APPLICATION

(11) **EP 4 380 320 A1**
(43) Date of publication of application: **05.06.2024**
(21) Application number: 23212561.7
(22) Date of filing: 28.11.2023
(51) Int. Cl.: H05K 1/02, H05K 1/18, H05K 3/46, H01L 23/538

(54) **CIRCUIT BOARD WITH BUILT-IN COMPONENTS**

(30) Priority: 01.12.2022 JP 2022192976; 22.05.2023 JP 2023083820
(71) Applicant: Nabtesco Corporation, Tokyo 102-0093 (JP)
(72) Inventor: Koizumi, Katsuhiro, Tokyo, 102-0093 (JP); Inada, Taro, Tokyo, 102-0093 (JP); Nakamura, Kazuhito, Tokyo, 102-0093 (JP)
(74) Representative: Grünecker Patent- und Rechtsanwälte PartG mbB

(57) **Abstract**

s: a first conductive wiring layer (10); a second conductive wiring layer (20) stacked on the first conductive wiring layer (10); an insulating layer (30) formed between the first conductive wiring layer (10) and the second conductive wiring layer (20); at least one pair of semiconductor elements built in the insulating layer (30) and each including a first electrode terminal and a second electrode terminal. The first electrode terminal (41) of a first semiconductor element (40), which is one of the pair of the semiconductor elements, is connected to the first conductive wiring layer (10), the second electrode terminal (52) of a second semiconductor element (50), which is the other of the pair of semiconductor elements, is connected to the second conductive wiring layer (20), and the first conductive wiring layer (10) and the second conductive wiring layer (20) are formed such that a current flowing through the first conductive wiring layer (10) and a current flowing through the second conductive wiring layer (20) are symmetrical and opposite when viewed from a direction passing through the first conductive wiring layer (10) and the second conductive wiring layer (20).

## Description

### BACKGROUND OF THE INVENTION

### 1. Field of the Invention

The present invention relates to circuit boards with built-in components.

### 2. Description of the Related Art

In conventional electronic devices, technologyZ for mounting electronic components on the surface of a printed circuit board has been generally used. Meanwhile, it can be expected to increase the density in electronic circuits by adopting a circuit board with built-in components in which electronic components are mounted inside a printed circuit board.

### [Patent Literature 1] JP2013-222924

When a current flows through an input wiring (for example, a copper foil pattern from a P potential electrode and an N potential electrode to a switching FET) in an electronic device in which a circuit board with built-in components is used, a magnetic flux in a direction encircling the copper foil pattern is generated (right-handed screw law). When a magnetic flux is generated around a conductor, the conductor has an inductance component. Current intermittence occurs at ON/OFF transition of the switching FET (point of time of switching). In the presence of inductance in the wiring, the current intermittence and the inductance generate a voltage. This causes a noise. In the field of power electronics, particularly, switching operation is indispensable so that noise reduction is strongly desired.

Patent literature 1 discloses a technology for enhancing the shielding performance of a circuit board with built-in components and improving reliability against noise. However, this technology cannot reduce a noise caused by electronic component operation that involves a switching operation.

### SUMMARY OF THE INVENTION

The present invention addresses the issue described above, and a purpose thereof is to reduce a noise of a circuit board with built-in components in which an electronic component that involves a switching operation is mounted.

A circuit board with built-in components according to an aspect of the present invention includes: a first conductive wiring layer; a second conductive wiring layer stacked on the first conductive wiring layer; an insulating layer formed between the first conductive wiring layer and the second conductive wiring layer; at least one pair of semiconductor elements built in the insulating layer and each including a first electrode terminal and a second electrode terminal. The first electrode terminal of a first semiconductor element, which is one of the pair of the semiconductor elements, is connected to the first conductive wiring layer, the second electrode terminal of a second semiconductor element, which is the other of the pair of semiconductor elements, is connected to the second conductive wiring layer, and the first conductive wiring layer and the second conductive wiring layer are formed such that a current flowing through the first conductive wiring layer and a current flowing through the second conductive wiring layer are symmetrical and opposite when viewed from a direction passing through the first conductive wiring layer and the second conductive wiring layer.

In the circuit board with built-in components according to an embodiment, a first power supply terminal for the first semiconductor element may be provided on the first conductive wiring layer, and a second power supply terminal for the second semiconductor element may be provided on the second conductive wiring layer. The first power supply terminal and the second power supply terminal are arranged at symmetrical positions as seen from a direction passing through the first conductive wiring layer and the second conductive wiring layer. In another embodiment, the first power supply terminal and the second power supply terminal are arranged at positions facing each other across the insulating layer.

The circuit board with built-in components according to an embodiment may include a capacitor. The capacitor is arranged along an axis of symmetry of the current flowing through the first conductive wiring layer and the current flowing through the second conductive wiring layer and connect the first conductive wiring layer and the second conductive wiring layer.

The circuit board with built-in components according to an embodiment includes: a conductive component between the first semiconductor element and the second semiconductor element. The insulating layer is formed between the first conductive wiring layer and the second conductive wiring layer. The first semiconductor element and the second semiconductor element are arranged such that the first electrode terminals of the semiconductor elements are arranged to be on the same plane and the second electrode terminals of the semiconductor elements are arranged to be on the same plane. The first electrode terminal of the first semiconductor element is exposed on a first side surface of the insulating layer. The second electrode terminal of the second semiconductor element is exposed on a second side surface of the insulating layer opposite to the first side surface. The second electrode terminal of the first semiconductor element and the first electrode terminal of the second semiconductor element are connected via the conductive component.

The circuit board with built-in components according to an embodiment may include an output wiring layer arranged on the same plane as the first conductive wiring layer and connected to the first electrode terminal of the second semiconductor element.

The circuit board with built-in components according to an embodiment may include an output wiring layer arranged on the same plane as the second conductive wiring layer and connected to the second electrode terminal of the first semiconductor element.

Optional combinations of the aforementioned constituting elements, and mutual substitution of constituting elements and implementations of the present invention between methods, apparatuses, programs, transitory or non-transitory recording mediums carrying the program, systems, etc. may also be practiced as additional modes of the present invention.

According to the disclosure, it is possible to reduce a noise of a circuit board with built-in components in which an electronic component that involves a switching.

### BRIEF DESCRIPTION OF THE DRAWINGS

Embodiments will now be described by way of examples only, with reference to the accompanying drawings which are meant to be exemplary, not limiting and wherein like elements are numbered alike in several Figures in which:
Fig. 1 is a cross-sectional view of a circuit board with built-in components according to the embodiment from a longitudinal side;
Fig. 2 is a schematic side view of the first semiconductor element;
Figs. 3A and 3B are schematic views of the circuit board with built-in components of Fig. 1 from above, where

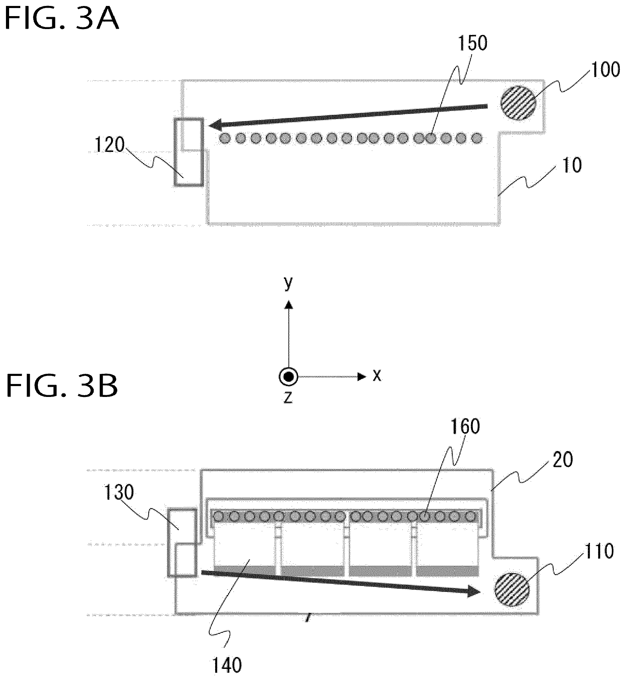

Fig. 3A shows the second conductive wiring layer, and Fig. 3B shows the first conductive wiring layer;

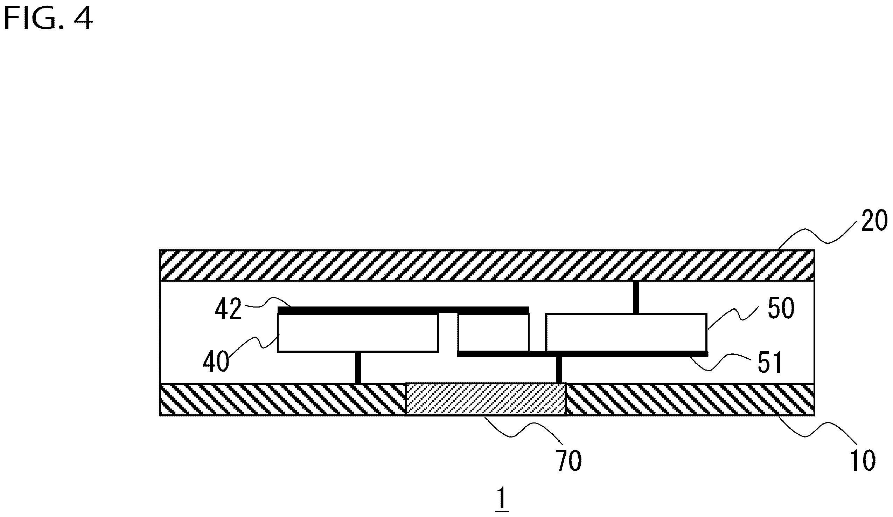

Fig. 4 is a cross-sectional view of the circuit board with built-in components according to an embodiment from the longitudinal side;

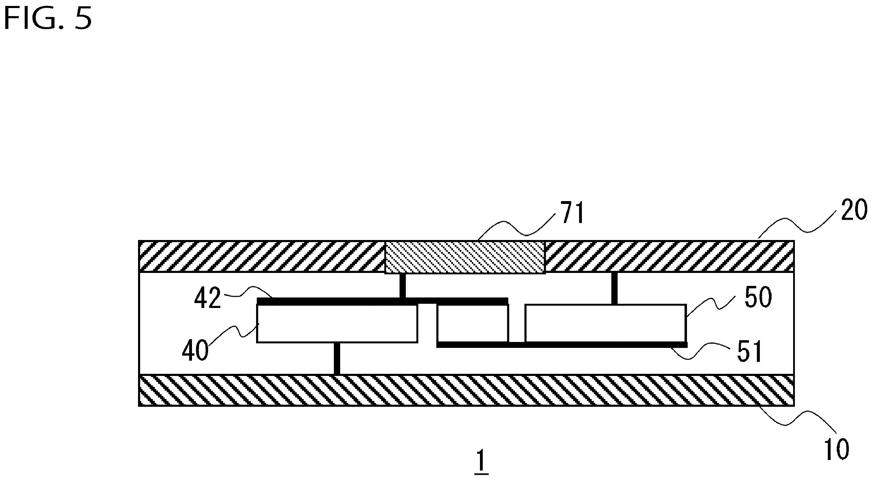

Fig. 5 is a cross-sectional view of the circuit board with built-in components of Fig. 4 and according to the embodiment from the longitudinal side;

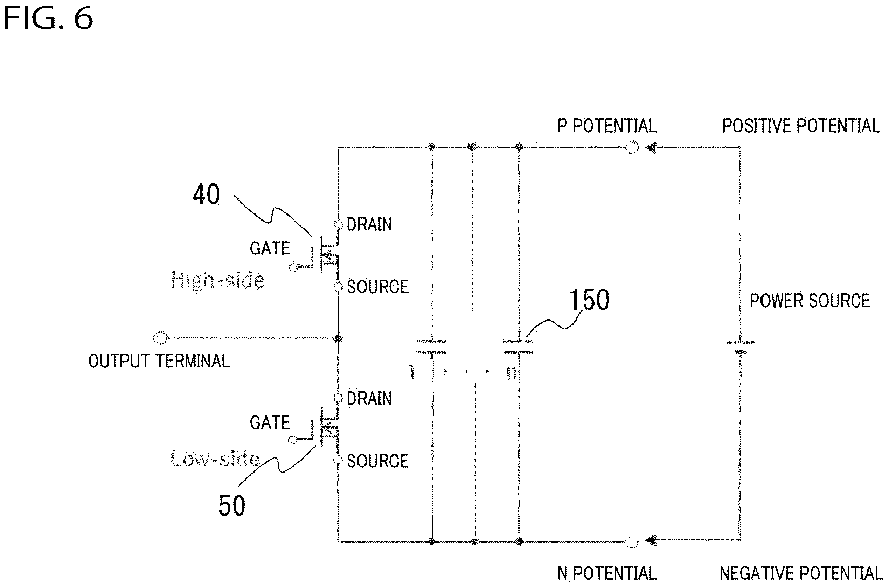

Fig. 6 is a circuit diagram on the circuit board with built-in components;

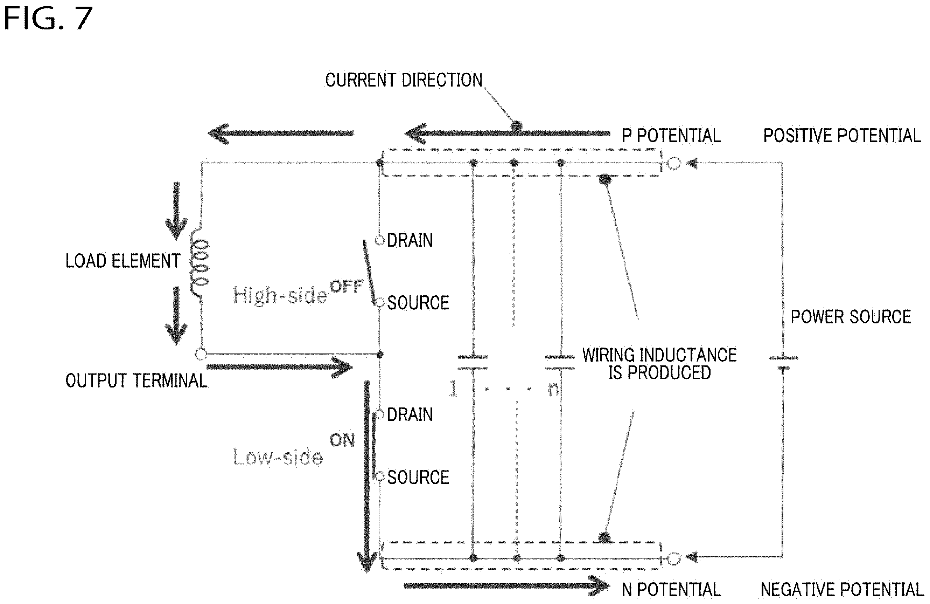

Fig. 7 shows the state of the current flowing through the circuit of Fig. 6 when the high side is OFF and the low side is ON;

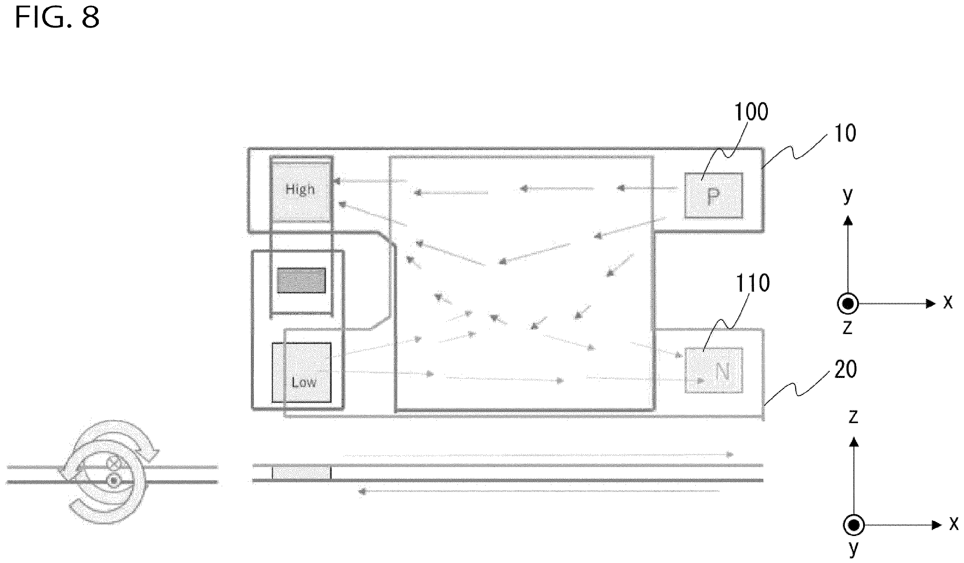

Fig. 8 schematically shows currents flowing through the first conductive wiring layer and the second conductive wiring layer according to the embodiment; and

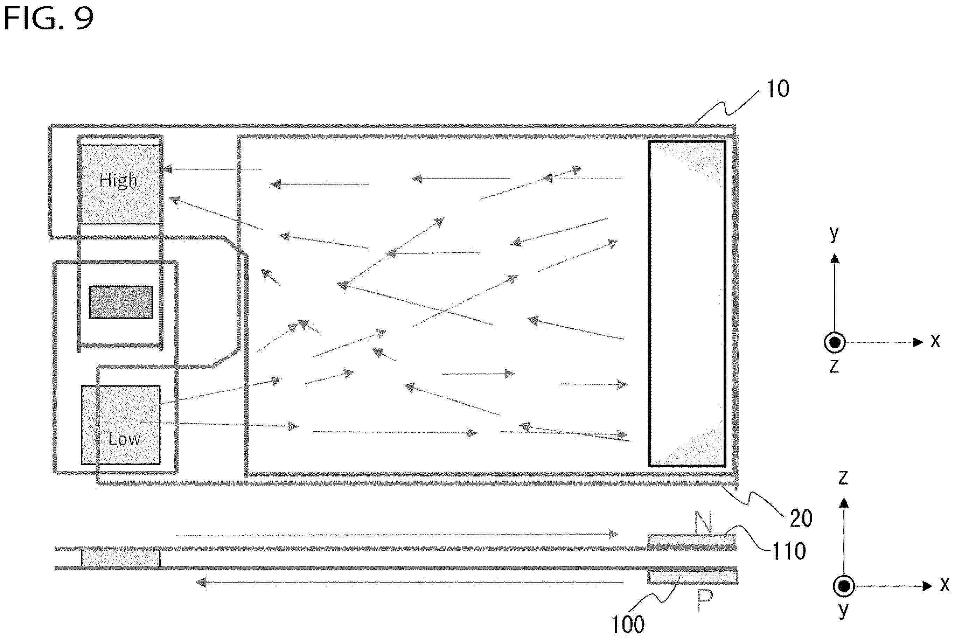

Fig. 9 schematically shows currents flowing through the first conductive wiring layer and the second conductive wiring layer of Fig. 8 and according to another embodiment.

### DETAILED DESCRIPTION OF THE INVENTION

Hereinafter, the invention will be described based on a preferred embodiment with reference to drawings. The embodiment does not limit the scope of the invention but exemplifies the invention. Not all of the features and the combinations thereof described in the embodiment are necessarily essential to the invention. Identical or like constituting elements, members, processes shown in the drawings are represented by identical symbols and a duplicate description will be omitted as appropriate. The scales and shapes shown in the figures are defined for convenience's sake to make the explanation easy and shall not be interpreted limitatively unless otherwise specified. Terms like "first", "second", etc. used in the specification and claims do not indicate an order or importance by any means unless otherwise specified and are used to distinguish a certain feature from the others. Those of the members that are not important in describing the embodiment are omitted from the drawings.

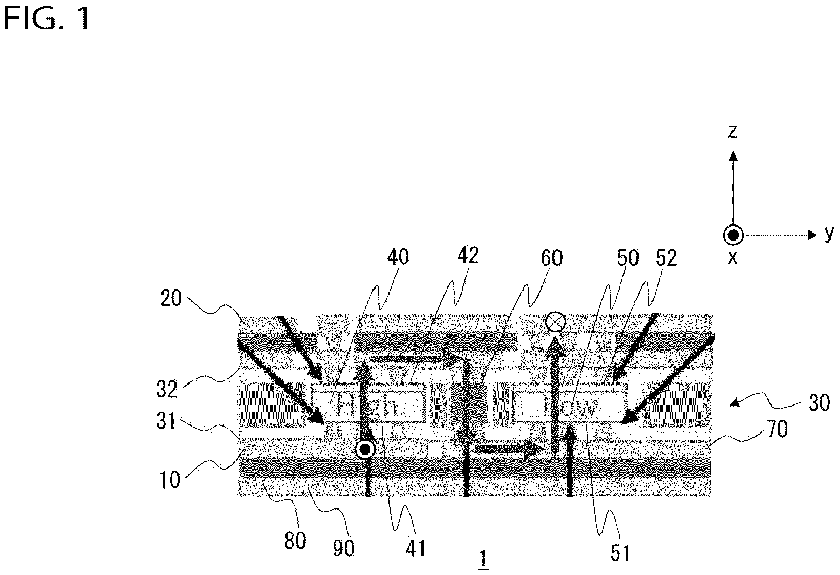

Fig. 1 is a cross-sectional view of a circuit board with built-in components 1 according to the embodiment placed on a horizontal plane from the longitudinal side. In this specification, the longitudinal direction of the circuit board placed on a horizontal plane is defined as the x axis, the horizontal direction is defined as the y axis, and the vertically upward direction is defined as the z axis. The circuit board with built-in components 1 includes a first conductive wiring layer 10 and a second conductive wiring layer 20. The second conductive wiring layer 20 is stacked on the first conductive wiring layer 10. An insulating layer 30 is formed between the first conductive wiring layer 10 and the second conductive wiring layer 20. The circuit board with built-in components 1 includes a pair of semiconductor elements built in the insulating layer 30. The pair of semiconductor elements includes a first semiconductor element 40 and a second semiconductor element 50. The circuit board with built-in components 1 includes a conductive component 60 between the first semiconductor element 40 and the second semiconductor element 50.

In this example, the first conductive wiring layer 10 and the second conductive wiring layer 20 are made of a copper foil.

The insulating layer 30 may include a core layer and a prepreg member. Hereinafter, the surface of the insulating layer 30 facing the first conductive wiring layer 10 will be referred to as a first side surface 31, and the surface facing the second conductive wiring layer 20 will be referred to as a second side surface 32.

The first semiconductor element 40 includes a first electrode terminal 41 and a second electrode terminal 42. The second semiconductor element 50 includes a first electrode terminal 51 and a second electrode terminal 52. By way of one example, the first semiconductor element 40 and the second semiconductor element 50 are FETs (field effect transistors). In this case, the first electrode terminals 41 and 51 are drain electrode terminals, and the second electrode terminals 42 and 52 are source electrode terminals.

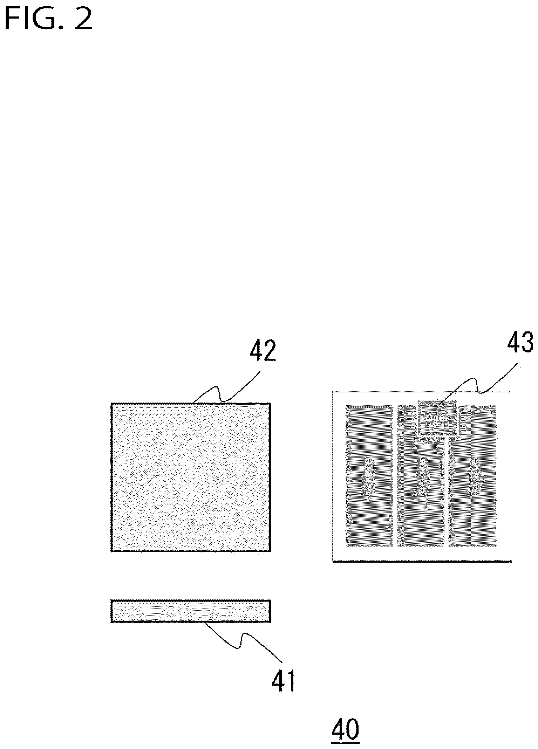

Fig. 2 is a schematic side view of the first semiconductor element 40 (FET). The first semiconductor element 40 includes a first electrode terminal 41 (drain electrode terminal) on the lower side, a second electrode terminal 42 (source electrode terminal) on the upper side, and a third electrode terminal (gate electrode terminal) formed in a part of the source electrode surface. In the following description, the third electrode terminal may be omitted. The same applies to the second semiconductor element 50.

Reference is made back to Fig. 1. The first electrode terminal 41 of the first semiconductor element 40 is connected to the first conductive wiring layer 10. The second electrode terminal 52 of the second semiconductor element 50 is connected to the second conductive wiring layer 20.

The first electrode terminal 41 of the first semiconductor element 40 and the first electrode terminal 51 of the second semiconductor element 50 are arranged to be on the same plane. Similarly, the second electrode terminal 42 of the first semiconductor element 40 and the second electrode terminal 52 of the second semiconductor element 50 are arranged to be on the same plane. That is, the first semiconductor element 40 and the second semiconductor element 50 are arranged in the same orientation in the vertical direction.

The first electrode terminal 41 of the first semiconductor element 40 is exposed on the first side surface 31 of the insulating layer 30. The second electrode terminal 42 of the first semiconductor element 40 and the first electrode terminal 51 of the second semiconductor element are connected via the conductive component 60.

The conductive component 60 of this example is formed by a copper block.

Figs. 3A and 3B are schematic views of the circuit board with built-in components 1 from above. Fig. 3A shows the second conductive wiring layer 20, and Fig. 3B shows the first conductive wiring layer 10. Regions 120 and 140 are regions in which the first semiconductor element 40 and the second semiconductor element 50 are arranged.

As shown in Fig. 3A, a first power supply terminal 100 is provided at the end of the first conductive wiring layer 10 opposite to the region 120. As shown in Fig. 3B, a second power supply terminal 110 is provided at the end of the second conductive wiring layer 20 opposite to the region 130. The first power supply terminal 100 and the second power supply terminal 110 are arranged at symmetrical positions as seen from the direction passing through the first conductive wiring layer 10 and the second conductive wiring layer 20.

In the circuit built on the circuit board with built-in components 1 of this example, the first semiconductor element 40 and the second semiconductor element 50 function as switches. In this case, the first semiconductor element 40 is arranged on the high side, and the second semiconductor element 50 is arranged on the low side. In this case, the first power supply terminal 100 is placed at a P potential, and the second power supply terminal 110 is placed at an N potential.

Hereinafter, the current flowing through the above circuit will be described. The current flowing out from the first power supply terminal 100 flows through the first conductive wiring layer 10 into the first electrode terminal 41 of the first semiconductor element 40. The current flowing into the first semiconductor element 40 flows out from the second electrode terminal 42, flows through the conductive component 60 into the first electrode terminal 51 of the second semiconductor element 50. The current flowing into the second semiconductor element 50 flows out from the second electrode terminal 52 and flows through the second conductive wiring layer 20 into the second power supply terminal 110. Figs. 1, 3A, and 3B schematically show these currents with thick arrows.

The first conductive wiring layer 10 and the second conductive wiring layer 20 are formed such that the current flowing through the first conductive wiring layer 10 and the current flowing through the second conductive wiring layer 20 are symmetrical and opposite when viewed from the direction passing through the first conductive wiring layer 10 and the second conductive wiring layer 20. This point will be discussed in more detail later. In accordance with this embodiment, such current arrangement can be realized by arranging the first power supply terminal 100 and the second power supply terminal 110 at symmetrical positions when viewed from the direction passing through the first conductive wiring layer 10 and the second conductive wiring layer 20.

In another embodiment, the first power supply terminal 100 and the second power supply terminal 110 are arranged at positions facing each other across the insulating layer 30. The current arrangement as described above can also be realized by arranging the first power supply terminal 100 and the second power supply terminal 110 in this way.

The circuit board with built-in components 1 includes a plurality of (for example, four) capacitors 140 on the upper surface of the second conductive wiring layer 20. The capacitor 140 is arranged along the axis of symmetry of the current flowing through the first conductive wiring layer 10 and the current flowing through the second conductive wiring layer 20. The capacitor 140 is connected to the first conductive wiring layer 10 via the terminal 150 and connected to the second conductive wiring layer 20 via the terminal 160. Therefore, the first conductive wiring layer 10 and the second conductive wiring layer 20 are connected to each other via the capacitor 140.

The circuit board with built-in components 1 includes an output wiring layer 70 arranged on the same plane as the first conductive wiring layer 10 and connected to the first electrode terminal 51 of the second semiconductor element 50. Fig. 4 is a cross-sectional view of the circuit board with built-in components 1 of this embodiment from the side.

In another embodiment, the circuit board with built-in components 1 includes an output wiring layer 71 arranged on the same plane as the second conductive wiring layer 20 and connected to the second electrode terminal 42 of the first semiconductor element 40. Fig. 5 is a cross-sectional view of the circuit board with built-in components 1 of this embodiment from the side.

The circuit board with built-in components 1 includes an insulating sheet 80 and a heat dissipating plate 90 on the lower surface of the first conductive wiring layer 10.

Hereinafter, the operation of the circuit built on the circuit board with built-in components 1 will be described in detail with reference to Figs. 6-9. Fig. 6 is a circuit diagram on the circuit board with built-in components 1. In the circuit of Fig. 6, the first semiconductor element 40 and the second semiconductor element 50 are connected in series as switching semiconductor elements. The first semiconductor element 40 is arranged on the high side, and the second semiconductor element 50 is arranged on the low side. A P potential (positive potential) is applied to the first electrode terminal 41 (drain electrode terminal) of the first semiconductor element 40, and an N potential (negative potential) is applied to the second electrode terminal 52 (source electrode terminal) of the second semiconductor element 50. The connection node between the second electrode terminal 42 (source electrode terminal) of the first semiconductor element 40 and the first electrode terminal 51 (drain electrode terminal) of the second semiconductor element 50 is the output terminal.

This circuit has a typical basic configuration of a power electronics circuit, and a three-phase inverter can be configured by, for example, connecting three of these circuits in parallel.

The operation of this circuit is characterized by complementary repetition of ON/OFF operations (switching operations) of the two switching semiconductor elements (the first semiconductor element 40 and the second semiconductor element 50). Fig. 7 shows the state of the current flowing through the circuit in one state (the high side is OFF and the low side is ON).

Referring to Fig. 7, the wiring (first conductive wiring layer 10) from the P potential to the drain electrode terminal (first electrode terminal 41) of the high-side switching element (first semiconductor element 40), and the wiring (second conductive wiring layer 20) from the N potential to the source electrode (second electrode terminal 52) of the low-side switching element (second semiconductor element 50) are wirings (copper foils of the printed board) respectively having a certain length or more. In an actual device, the component arrangement has a finite size so that these wiring lengths cannot necessarily be minimized.

When a current flows through these wirings, a magnetic flux in a direction encircling the wirings is generated according to the right-handed screw law. Since the wiring has an inductance, repeated ON/OFF operations of the two switching semiconductor elements when continued produce a noise voltage between the drain electrode terminal and the source electrode terminal of the switching elements due to a transient current.

Fig. 8 schematically shows a current flowing through the first conductive wiring layer 10 and the second conductive wiring layer 20 when, according to this embodiment, the first conductive wiring layer 10 and the second conductive wiring layer 20 are formed such that the current flowing through the first conductive wiring layer 10 and the current flowing through the second conductive wiring layer 20 are symmetrical and opposite when viewed from the direction passing through the first conductive wiring layer 10 and the second conductive wiring layer 20. By adopting such a configuration, the magnetic flux generated by the current flowing through the first conductive wiring layer 10 and the magnetic flux generated by the current flowing through the second conductive wiring layer 20 cancel each other. Further, in the case of, for example, a three-phase inverter in which three of the circuit shown in Fig. 7 are connected in parallel, the benefit of inductance reduction due to magnetic flux cancellation can be similarly realized not only by the difference in the direction of current but also by reversing the tendency of temporal change such as increase or decrease in the current. Even if the directions of current indicated by the thick arrows in Figs. 3A and 3B are the same, for example, the same benefit of inductance reduction can be obtained if the tendency (i.e., whether the current has a tendency to increase or a tendency to decrease) differs mutually. According to this principle, noise associated with switching operation can be reduced.

Fig. 9 is a schematic diagram of the circuit board with built-in components 1 seen from above when the first power supply terminal 100 and the second power supply terminal 110 are arranged according to another embodiment. In this embodiment, the first power supply terminal 100 is provided on the first conductive wiring layer 10, the second power supply terminal 110 is provided on the second conductive wiring layer 20, and the first power supply terminal 100 and the second power supply terminal 110 are arranged at positions facing each other across the insulating layer 30.

Hereinafter, the advantages provided by the embodiment will be described.

In an embodiment in which the first conductive wiring layer 10 and the second conductive wiring layer 20 are formed such that the current flowing through the first conductive wiring layer 10 and the current flowing through the second conductive wiring layer 20 are symmetrical and opposite when viewed from the direction passing through the first conductive wiring layer 10 and the second conductive wiring layer 20, the currents flow in the opposite directions through the first conductive wiring layer 10 and the second conductive wiring layer 20, and the axes thereof are substantially aligned. Therefore, noise associated with switching operation can be reduced without requiring any additional elements such as a conventional snubber circuit.

In an embodiment in which the first power supply terminal 100 and the second power supply terminal 110 are arranged at symmetrical positions when viewed from the direction passing through the first conductive wiring layer 10 and the second conductive wiring layer 20, the magnetic flux generated by the current flowing through the first conductive wiring layer 10 and the magnetic flux generated by the current flowing through the second conductive wiring layer 20 can cancel each other. Therefore, noise associated with switching operation can be reduced by the arrangement of components.

The magnetic flux generated by the current flowing through the first conductive wiring layer 10 and the magnetic flux generated by the current flowing through the second conductive wiring layer 20 can cancel each other similarly by an arrangement in which the first power supply terminal 100 and the second power supply terminal 110 are arranged at positions facing each other across the insulating layer 30. Therefore, noise associated with switching operation can be reduced by the arrangement of components.

In an embodiment in which the first semiconductor element 40 and the second semiconductor element 50 are arranged such that the first electrode terminals thereof are arranged to be on the same plane and the second electrode terminals thereof are arranged to be the same plane, the first conductive wiring layer 10 and the second conductive wiring layer 20 can be provided to face each other. This can enhance the effect of magnetic flux cancellation, make the entire board more compact, and increase the scale of integration.

In further accordance with this embodiment, a step of reversing the mounting arrangement of the first semiconductor element 40 and the second semiconductor element 50 at the time of manufacturing is not necessary. In general, parts manufacturers supply the same parts in such a form that the electrode surfaces are aligned in the same direction. Reversing an adsorbed semiconductor element when mounting it on a printed circuit board complicates the process and requires an additional plating treatment, etc. In this embodiment, such complexity of the process can be reduced.

Further, the conductive component 60 connecting the first semiconductor element 40 and the second semiconductor element 50 need only be arranged side by side with and in the same layer as the first semiconductor element 40 and the second semiconductor element 50. Therefore, the process can be simplified by arranging the conductive component 60 concurrently with mounting the semiconductor elements.

In an embodiment in which the capacitor 140 connecting the first conductive wiring layer 10 and the second conductive wiring layer 20 is arranged along the axis of symmetry of the current flowing through the first conductive wiring layer 10 and the current flowing through the second conductive wiring layer 20, the effect of magnetic flux cancellation can be increased without impairing the symmetry of the current flowing through the first conductive wiring layer 10 and the current flowing through the second conductive wiring layer 20.

In an embodiment in which the output wiring layer 70 connected to the first electrode terminal 51 of the second semiconductor element 50 is arranged on the same plane as the first conductive wiring layer, the thickness of the board can be reduced so that the scale of integration can be increased.

In an embodiment in which the output wiring layer 71 connected to the second electrode terminal 42 of the first semiconductor element 40 is arranged on the same plane as the second conductive wiring layer, too, the thickness of the board can be reduced so that the scale of integration can be increased.

In an embodiment in which an insulating sheet 80 and a heat dissipating plate 90 are provided on the lower surface of the first conductive wiring layer 10, the heat generated by the electronic component can be effectively dissipated so that the problem of heat generation accompanying internal mounting of components can be solved.

Described above is an explanation based on an embodiment. The embodiment is intended to be illustrative only and it will be understood by those skilled in the art that variations and modifications are possible within the claim scope of the present invention and that such variations and modifications are also within the claim scope of the present invention. Therefore, the description in this specification and the drawings shall be treated to serve illustrative purposes and shall not limit the scope of the invention.

The semiconductor element of the embodiment is an FET. However, the semiconductor element is not limited to this and may be any switching semiconductor such as an IGBT (insulated gate bipolar transistor) and a MOSFET (metal oxide semiconductor field effect transistor). The semiconductor material may be any suitable material such as Si, SiC, GaN, and Ga₂O3. According to this modification, flexibility of configuration can be increased.

The substrate material (FR4, CEM3, etc.) and the insulating layer material such as a prepreg are not particularly limited and may be any suitable material. The thickness of the conductor layer is not particularly limited and may be thicker or thinner than 36 µm, which is common. The present technology can be applied to both rigid substrates and flexible substrates. According to this variation, flexibility of configuration can be increased.

The conductive component of the embodiment is formed by a copper block. The surface of the copper block may be plated in advance. The conductive component is not limited to a copper block and may be made by stacking interlayer VIAs. The material of the conductive component is not limited to copper and may be any conductive soldering material. According to this variation, flexibility of configuration can be increased.

The circuit board with built-in components of the embodiment has a two-layer structure in which one printed circuit board having a P potential and one having an N potential are stacked. However, the structure is not limited to this and may be, for example, a four-layer structure in which a total of four printed circuit boards including two printed circuit boards having a P potential and two having N potential are stacked. According to this variation, the effect of magnetic flux cancellation can be further enhanced by increasing the current flowing through the conductive wiring layer.

Any combination of the embodiment and the variation described above will also be useful as an embodiment of the present invention. New embodiments created by the combination provide the advantages of embodiment and the variation combined.

An explanation based on the embodiment and variations has been given above. In understanding the technical idea derived from abstracting the embodiment and the variations, the technical idea shall not be interpreted as being limited to the details of the embodiment and the variations. The embodiment and the variations described above are merely specific examples, and a number of design modifications such as modification, addition, deletion, etc. of constituting elements may be made. The details subject to such design modification are emphasized in the embodiment by using a phrase "embodiment". However, details not referred to as such are also subject to design modification.

### [INDUSTRIAL APPLICABILITY]

Circuit boards with built-in components accoding to above embodiments can be widely used in power electronics circuits such as motor inverters, DCDC converters, ACDC converters, and DCAC inverters.

### [REFERENCE SIGNS LIST]

1 circuit board with built-in components,
10 first conductive wiring layer,
20 second conductive wiring layer,
30 insulating layer,
40 first semiconductor element,
41 first electrode terminal of first semiconductor element,
42 second electrode terminal of first semiconductor element,
50 second semiconductor element,
51 first electrode terminal of second semiconductor element,
52 second electrode terminal of second semiconductor element,
60 conductive component,
70 output wiring layer,
80 insulating sheet,
90 heat dissipating plate,
100 first power supply terminal,
110 second power supply terminal,
120 region,
130 region,
140 capacitor,
150 terminal,
160 terminal.

## Claims

1. A circuit board with built-in components comprising:
a first conductive wiring layer (10);
a second conductive wiring layer (20) stacked on the first conductive wiring layer (10);
an insulating layer (30) formed between the first conductive wiring layer (10) and the second conductive wiring layer (20);
at least one pair of semiconductor elements built in the insulating layer (30) and each including a first electrode terminal and a second electrode terminal, wherein
the first electrode terminal (41) of a first semiconductor element (40), which is one of the pair of the semiconductor elements, is connected to the first conductive wiring layer (10),
the second electrode terminal (52) of a second semiconductor element (50), which is the other of the pair of semiconductor elements, is connected to the second conductive wiring layer (20), and
the first conductive wiring layer (10) and the second conductive wiring layer (20) are formed such that a current flowing through the first conductive wiring layer (10) and a current flowing through the second conductive wiring layer (20) are symmetrical and opposite when viewed from a direction passing through the first conductive wiring layer (10) and the second conductive wiring layer (20).

2. The circuit board with built-in components (1) according to claim 1, wherein
a first power supply terminal (100) for the first semiconductor element is (40) provided on the first conductive wiring layer (10),
a second power supply terminal (110) for the second semiconductor element (50) is provided on the second conductive wiring layer (20), and
the first power supply terminal (100) and the second power supply terminal (110) are arranged at symmetrical positions as seen from a direction passing through the first conductive wiring layer (10) and the second conductive wiring layer (20).

3. The circuit board with built-in components (1) according to claim 1, wherein
a first power supply terminal (100) for the first semiconductor element (40) is provided on the first conductive wiring layer (10),
a second power supply terminal (110) for the second semiconductor element (50) is provided on the second conductive wiring layer (20),
the first power supply terminal (100) and the second power supply terminal (110) are
arranged at positions facing each other across the insulating layer (30).

4. The circuit board with built-in components (1) according to any one of claims 1 through 3, comprising:
a capacitor (140) arranged along an axis of symmetry of the current flowing through the first conductive wiring layer (10) and the current flowing through the second conductive wiring layer (20) and connecting the first conductive wiring layer (10) and the second conductive wiring layer (20).

5. The circuit board with built-in components (1) according to any one of claims 1 through 3, comprising:
a conductive component (60) between the first semiconductor element (40) and the second semiconductor element (50), wherein
the insulating layer (30) is formed between the first conductive wiring layer (10) and the second conductive wiring layer(20),
the first semiconductor element (40) and the second semiconductor element (50) are arranged such that the first electrode terminals of the semiconductor elements are arranged to be on the same plane and the second electrode terminals of the semiconductor elements are arranged to be on the same plane,
the first electrode terminal (41) of the first semiconductor element (40) is exposed on a first side surface of the insulating layer (30),
the second electrode terminal (52) of the second semiconductor element (50) is exposed on a second side surface of the insulating layer (30) opposite to the first side surface, and
the second electrode terminal (42) of the first semiconductor element (40) and the first electrode terminal (51) of the second semiconductor element (50) are connected via the conductive component.

6. The circuit board with built-in components (1) according to claim 5, comprising:
an output wiring layer (70) arranged on the same plane as the first conductive wiring layer (10) and connected to the first electrode terminal (51) of the second semiconductor element (50).

7. The circuit board with built-in components (10) according to claim 5, comprising:
an output wiring layer (70) arranged on the same plane as the second conductive wiring layer (20) and connected to the second electrode terminal (42) of the first semiconductor element (40).
